(19) Europäisches Patentamt

European Patent Office

Office européen des brevets

(11) EP 0 970 932 A1

(12) EUROPEAN PATENT APPLICATION

(43) Date of publication:
12.01.2000 Bulletin 2000/02

(51) Int Cl.⁷: **C04B 35/581**, H01L 23/15, C04B 35/64, C04B 35/58

(21) Application number: 99305372.7

(22) Date of filing: 06.07.1999

(84) Designated Contracting States:
**AT BE CH CY DE DK ES FI FR GB GR IE IT LI LU MC NL PT SE**
Designated Extension States:
**AL LT LV MK RO SI**

(30) Priority: **10.07.1998 JP 19533598**

(71) Applicant: **Sumitomo Electric Industries, Ltd.**
**Osaka-shi, Osaka 541-0041 (JP)**

(72) Inventors:
• **Natsuhara, Masuhiro, c/o Itami Works**
**Itami-shi, Hyogo (JP)**

• **Nakata, Hirohiko, c/o Itami Works**
**Itami-shi, Hyogo (JP)**
• **Tanaka, Motoyuki, c/o Itami Works**
**Itami-shi, Hyogo (JP)**
• **Murase, Yasuhiro, c/o Itami Works**
**Itami-shi, Hyogo (JP)**

(74) Representative:
**Cross, Rupert Edward Blount et al**
**BOULT WADE TENNANT,**
**27 Furnival Street**
**London EC4A 1PQ (GB)**

(54) **Ceramic base material**

(57)    A ceramic base material that is reduced in distortion caused by high-temperature heat treatment. A ceramic base material having sintering agents and satisfying the following formula:

$$a/b \leqq 1.3,$$

where

a: the larger of c1 and c2,
b: the smaller of c1 and c2,

c1: the ratio "k" at a main-surface side,
c2: the ratio "k" at the other main-surface side,

$$k = s/m,$$

s: the fluorescent X-ray-detected strength of the constituent elements of the sintering agents,
m: the fluorescent X-ray-detected strength of the main-constituent elements.

FIG. 1

**Description**

The present invention relates to a ceramic base material including sintering agents as an auxiliary constituent, particularly a ceramic base material including uniformly distributed sintering agents that contribute to the small heat distortion of the base material.

Sintering agents have been used for facilitating the sintering of ceramics. Particularly, when a ceramic consists mainly of a non-oxide, such as nitride or carbide, which is responsible for difficulty in sintering, sintering agents are indispensable to obtain a closely-packed structure. A ceramic consisting mainly of nitride such as aluminum nitride or silicon nitride cannot be packed closely without the aid of sintering agents unless the ceramic is sintered at high temperature and high pressure. In other words, sintering agents play an important role in these types of ceramics. For example, aluminum nitride ceramics, which consist mainly of aluminum nitride, have been aided by compounds of alkaline earth elements (II a group) or compounds of rare earth elements (IIIa group) as described in unexamined published Japanese patent applications Tokukaisho 63-190761, Tokukaisho 61-10071, and Tokukaisho 60-71575 and published Japanese patent 2666942. Almost the same is applicable to silicon nitride ceramics. These constituents in sintering agents react with impurities in the main constituent of ceramics during the sintering process, melt, facilitate the formation of closely-packed structures, and finally form the boundary phases between the crystal grains of the main constituent.

In order to make a ceramic sintered body homogeneous, it is necessary to distribute the grain-boundary phases uniformly, which contain the constituents of sintering agents, throughout the sintered body. To achieve this, reducing the quantity of sintering agents, evenly mixing material powders, and other various means have been devised. For instance, examined published Japanese patent application Tokukohei 7-121829 discloses a method in which a formed body including sintering agents is buried in carbon to be sintered for no less than four hours so that the remaining sintering agents are reduced to a minimal quantity to yield high thermal conductivity and total homogeneity. Another application Tokukaihei 1-203270 discloses a method in which a small amount of minute organometallic salt is added into sintering agents to achieve uniform mixture of material constituents.

However, the method of Tokukohei 7-121829 allows a large amount of evaporation of sintering agents from the surface of a sintered body due to prolonged sintering, resulting in non-uniform distribution of sintering agents in the completed sintered body. The prolonged sintering also increases the energy cost. The method of Tokukaihei 1-203270 uses a small quantity of sintering agents and hence requires sintering at high temperature, raising the possibility of the problems described above. On aluminum nitride ceramics, silicon nitride ceramics, and other ceramics that require the use of sintering agents for acquiring a closely-packed structure, studies have been concentrated on the sintering agents in order to improve their practical performance, such as an increase in thermal conductivity of aluminum nitride ceramics and an increase in mechanical strength of silicon nitride ceramics. Consequently, a number of studies have been done on a host of sintering agents and on the control of the quantity of the sintering agents. On the other hand, only a small number of studies have been made thus far on the uniform distribution of sintering agents, so that sufficient results are yet to be reported.

Focusing attention on the above-mentioned points, the present inventors conducted a close study to verify that insufficiently distributed sintering agents in a sintered body aggravate the distortion of the sintered body through the heat treatment after the sintering. We demonstrated that ceramics consisting mainly of nitride are particularly liable to distort through the heat treatment in an oxidative atmosphere. An as-sintered laminar ceramic base material increases its sintering-produced warp through the heat treatment after the sintering. With a plate-shaped base material of which both the main surfaces are ground to become parallel with each other, subsequent heat treatment reproduces the warp. For instance, when aluminum nitride ceramic laminae were used to fabricate substrates for hybrid ICs, various combinations of thick-film circuit patterns each made of Ag, Ag-Pd, Cu, or other metal were formed on the ceramic base materials, and then an insulating layer made of oxide glass was paste-printed and baked in the atmosphere. In this case, the warp of the ceramic base materials was seen to increase through the baking process. The present invention has been conducted on the basis of the above findings. The challenge for the present inventors is to uniformly distribute sintering agents throughout a sintered ceramic base material and thereby reduce the above-mentioned additional distortion caused by the heat treatment after the sintering.

In order to solve the foregoing problems, the ceramic base material offered by the present invention has a small difference in the quantity of sintering agents between the two main-surface sides. More specifically, the ceramic base material of the present invention includes sintering agents and satisfies the following formula:

$$a/b \leqq 1.3,$$

where

a: the larger of c1 and c2,
b: the smaller of c1 and c2,
c1: the ratio "k" at a main-surface side,
c2: the ratio "k" at the other main-surface side,

$$k = s/m,$$

s: the fluorescent X-ray-detected strength of the constituent elements of the sintering agents,
m: the fluorescent X-ray-detected strength of the main-constituent elements.

In other words, the ceramic base material of the present invention does not exceed a 30% difference in the quantity of the sintering-agent between the two main surfaces.

The present invention offers a ceramic base material in which the ceramic consists mainly of nitride. The present invention further offers a ceramic base material in which the ceramic is an aluminum nitride ceramic.

The present invention enables the control of uniform distribution of sintering agents in a ceramic base material, suppressing the distortion after the sintering to a level that will not be harmful in use. It also unprecedentedly suppresses the increment in distortion of a base material during the heat treatment in the atmosphere for mounting semiconductor elements. As a result, the present invention offers a highly reliable ceramic base material that is capable of maintaining high precision in dimensions with stability during the manufacturing process and in practical use.

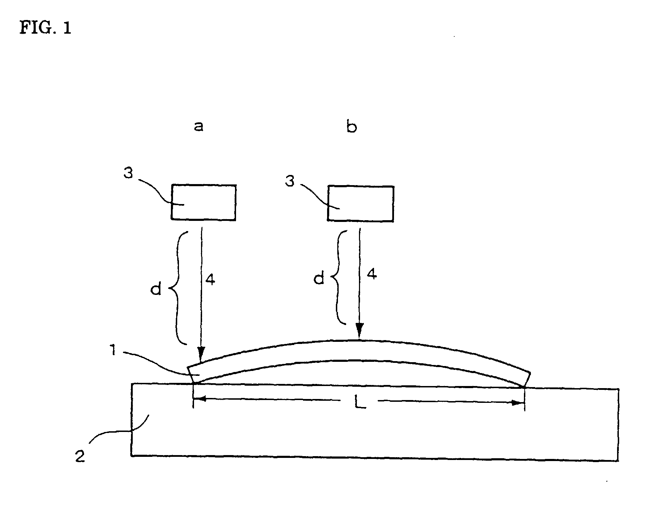

The accompanying figure explains the procedure for determining the warp of a plate-shaped base material in the present invention, and is provided by way of example.

As mentioned above, the ceramic base material offered by the present invention includes sintering agents and does not exceed a 30% difference in the quantity of sintering agents between the two main-surface sides. In the present invention, the quantity of the sintering agents is expressed by the ratio of the total strength of the fluorescent X-ray peaks on the constituent elements of the sintering agents to the strength on the main constituent element. Although this data is not obtained by chemical analysis, this should be considered insignificant, because we demonstrated that there is no virtual difference between the fluorescent X-ray-peak strength and the chemical analysis data when a strength ratio, or a quantity ratio, is adopted for the same population or for the populations manufactured in the same lot.

The determination procedure of the ratio of fluorescent X-ray-peak strength is explained by using examples in the following: For example, with an aluminum nitride ceramic sintered body having yttrium oxide ($Y_2O_3$) as the sintering agents, the quantity of the sintering agents, or the quantity corresponding to the concentration of the sintering agents at the measured point, is expressed in the following formula:

$$Y/(X + Y),$$

where

Y: the peak strength (a count number or a recorded peak pattern's area) of fluorescent X-rays of the Y element in the yttrium oxide as the constituent of the sintering agents, and
X: the corresponding strength of the Al element in the aluminum nitride as the main constituent.

With an aluminum nitride ceramic sintered body having a combination of calcium oxide (CaO) and yttrium oxide ($Y_2O_3$) as the sintering agents, the quantity of the sintering agents is expressed in the following formula:

$$(Y_1 + Y_2)/(X + Y_1 + Y_2),$$

where

$Y_1$: the peak strength of fluorescent X-rays of the Ca element,
$Y_2$: the corresponding strength of the Y element, and
X: the corresponding strength of the Al element in the main constituent.

Likewise, when a number of constituents are used as sintering agents, the quantity of the sintering agents is expressed in the following formula:

$$\sum Y/(X + \sum Y),$$

where $\sum Y$: the summation of the peak strengths of all the constituent elements.

In a sintered body, constituents of the sintering agents usually react with part of the main constituent and impurity elements in the main constituent to form resultant compounds. For instance, aluminum nitride as the main constituent and yttrium oxide as the sintering agents produce yttrium aluminate as a compound. Similarly, aluminum nitride as the main constituent and a combination of yttrium oxide and calcium oxide as the sintering agents produce yttrium aluminate, calcium aluminate, yttrium calcium aluminate, and other compounds. In the present invention, the quantity of sintering agents is expressed by the existent quantity of the constituent elements of the sintering agents without regard to the formation of compounds. The highest peak pattern is used to determine the peak strength of fluorescent X-rays. When a number of sintering agents are used and if peak positions of some of them overlap with one another, the peak strength of the overlapping sintering-agent elements is used as the value of "Y" described above. If the peak position of the main-constituent element overlaps with the peak position of a sintering-agent element, the value of the overlapping peak strength is allocated to the two elements in accordance with their weight ratio at the time of mixing for convenience to obtain their respective values of the peak strength.

As described earlier, in a ceramic base material including sintering agents, the magnitude of distortion of a sintered body after the heat treatment increases with increasing difference in the quantity of the sintering agents between the two main-surface sides. In other words, with a plate-shaped base material having two main surfaces, the magnitude of a warp produced by the sintering is amplified by the succeeding heat treatment according to the difference in the quantity of the sintering-agent constituents between the two main surfaces. Not only the magnitude of the distortion is affected by the main-surface size and shape of a base material but it also increases with increasing the frequency of sintering. We confirmed that the quantity difference exceeding 30% significantly increases the magnitude of distortion (warp in the case of a plate-shaped base material, for instance) and that the quantity difference not more than 30% generally decreases the increment in distortion. It is more desirable to reduce the quantity difference to 15% or less, because this further decreases the increment in distortion. In other words, the ceramic base material of the present invention includes sintering agents and decreases the increment in distortion after the heat treatment following the sintering by satisfying the following formula:

$$a/b \leqq 1.3,$$

where

a: the larger of c1 and c2,
b: the smaller of c1 and c2,
c1: the ratio "k" at a main-surface side,
c2: the ratio "k" at the other main-surface side,

$$k = s/m,$$

s: the fluorescent X-ray-detected strength of the constituent elements of the sintering agents,
m: the fluorescent X-ray-detected strength of the main-constituent elements.

The ceramic base material of the present invention further decreases the increment in distortion when it satisfies the following formula:

$$a/b \leqq 1.15,$$

where the definition of "a" and "b" is the same as before.

Though the mechanism remains uncertain, the oxidation phenomena of a base material seem to aggravate the distortion of the base material according to the difference in the quantity of the sintering agents, because this aggravation notably appears when a non-oxide ceramic sintered body is heat-treated in an oxidative atmosphere. For instance, the difference in the oxidation rate is considered to develop in the base material. We also confirmed that a ceramic consisting mainly of nitride shows this aggravation more remarkably than other non-oxide ceramics. With a ceramic consisting mainly of nitride, a non-oxidative sintering atmosphere is considered to help volatilization of added oxide-based sintering agents, causing easy development of a concentration difference of the sintering agents in a sintered base material. Incidentally, a silicon nitride ceramic is more noticeable in this phenomenon than a silicon carbide ceramic. An aluminum nitride ceramic shows this phenomenon more remarkably than other nitride ceramics.

Such a phenomenon is affected by the sintering method of a sintered body. The following is the explanation of the method for manufacturing the ceramic base material of the present invention:

The first method for preventing the uneven distribution of the sintering agents is to provide a setter between the formed bodies when they are charged into a sintering furnace. The setter should be made of a permeable high-melting-point metal or ceramic that is nonreactive with the constituents of the sintered bodies under sintering conditions and is free from softening and deformation. In comparison with the case where a number of formed bodies are placed together directly contacting one another during the sintering, the above method reduces the difference in the volatilization rate of sintering agents between the surface facing another formed body and the surface directly exposed to the sintering atmosphere, resulting in the reduction of the difference in the quantity of the sintering agents between the two surfaces after the sintering. In this method, it is recommended that a setter be placed on the uppermost formed body and under the lowermost formed body in addition to the setters between the formed bodies so that every formed body contacts a setter on either of the main surfaces. This enables the setters to evenly absorb the sintering agents that seep out of the two main surfaces of a formed body.

In order to suppress the distortion of a formed body during the sintering, it is desirable that a setter have a smooth surface and be small in undulation and unevenness over the entire surface. It is recommended that the roughness of the surface be comparable to the intended surface roughness of the sintered body. Depending on the application of the base material, it is desirable that the surface roughness be 5 $\mu$m or less in Rmax in most cases when the base material is used as a substrate for mounting semiconductor devices. A setter that meets the foregoing requirements is most suitably provided by the following method: first, a high-melting-point metal or carbon is used to produce bundled short fibers, wool, or cloth; second, the fibers, wool, or cloth is impregnated with ceramic constituents that are stable and nonreactive with the formed body at high temperatures; finally, the ceramic-impregnated body is press-formed. Formed bodies having a particular size or shape allow the use of the following material as a setter: (a) a sheet-shaped formed body made of a pure nitride ceramic that is stable at high temperatures such as porous boron nitride (BN); (b) a thin punched plate made of a nitride ceramic.

The second method for preventing the uneven distribution of the sintering agents is applied to a sintering method in which all the formed bodies are stacked. In this method, the sintering is carried out by burying the stacked formed bodies in a powder so that the powder can lie between the neighboring surfaces of the formed bodies. The powder should be nonreactive with the formed bodies under the sintering conditions (a powder including the above-described constituents, for example) or should be made of the main constituent of the formed body. In this case, it is desirable to place a setter made of the same material or a sheet made of the same material under the lowermost formed body in order to support the weight of the set of the formed bodies. The sheet should be low in bulk density and capable of maintaining the shape at the time of sintering. A thin layer of the setter material that is nonreactive with the formed body may also be formed beforehand over the entire surface of the individual formed bodies. These arrangements enable the equalization of the contact conditions of a formed body's surfaces with the atmospheric gas between the surface that is exposed to the atmosphere and the surface that faces another formed body's surface. As a result, both types of surfaces are treated under nearly the same atmospheric and heating conditions.

The first and second methods enable the reduction of the foregoing a/b ratio of the quantity of the sintering agents in a sintered body to 1.3 or less without regard to the size of a formed body. The ratio can be further reduced to 1.15 or less with a formed body having comparatively small dimensions. For the reduction of the ratio, it is also effective to practically stop the flow of the atmospheric gas or reduce the feeding rate of the gas from the outside at the melting point of the sintering agents or higher so that the effect of the flow of the atmospheric gas is reduced. For example, first, formed bodies are charged in a sintering furnace as explained above, and then the flow rate of the atmospheric gas is reduced at or above the melting point of the sintering agents. In the continuous-feed sintering under normal nitrogen pressure, in the case of aluminum nitride ceramics, a gas flow rate at the time of temperature rising is about 20 to 50 liter/min and it is desirable that the gas flow rate at or above the melting point of the sintering agents be reduced to 5 to 30 % or so of the gas flow rate at the time of temperature rising. Here the ratio of the gas flow rate at the melting point of the sintering agents or higher to the flow rate at the time of temperature rising is defined as "r". In this case, the gas pressure inside the furnace is maintained at about the atmospheric pressure. It is desirable that nearly the same "r" be adopted for other ceramics. The combination of the first or second charging method and the foregoing control of atmospheric conditions enables the reduction of the foregoing a/b ratio of the quantity of the sintering agents in a sintered body to 1.20 or less without regard to the size of a formed body. The combination can further reduce the ratio to 1.10 or less with a formed body having comparatively small dimensions. In the present invention, the setter used for sintering has a long life and is capable of enduring repeated use.

Means for obtaining features of the base material of the present invention are not limited to the above-mentioned means. For instance, it is possible to modify the method for charging formed bodies in a sintering furnace and sintering conditions in accordance with the shape and handling quantity of formed bodies. It is important to carry out proper measures not only for controlling the atmospheric and temperature conditions that govern the balance of the movement of the molten constituents of the sintering agents within the formed body and to the outside but also for achieving the balanced exchange of substances between the surfaces of the formed body and their surroundings. The method for manufacturing the ceramic base material offered by the present invention is not limited to the above-described manufacturing methods and the embodiments explained below, provided that the method satisfies the above-mentioned manufacturing principle.

In the present invention, the determination procedure for the warp of a ceramic base material is illustrated in the accompanying figure. A ceramic base material 1 is placed on a surface plate 2 as shown in the figure. A laser source 3 emits laser light 4. The light 4 scans diagonally from a corner of the rectangular surface of the base material 1 to the other corner to measure the distance "d" continuously. (A circular main surface is scanned diametrically, and an elliptic main surface major-axially.) A maximum difference dmax in the distance "d" is determined down to the order of $\mu$m. (Referring to the figure, if "d" assumes a maximum value at "a", the value is expressed in da; if "d" assumes a minimum value at "b", the value is expressed in db. Then, we obtain dmax = da - db.)

A value obtained by dividing the value of dmax by the total scanned distance (a length "L" expressed in mm when the "L" shows a diagonal distance in the figure) is defined as a warp (expressed in $\mu$m/mm).

In the present invention, a warp immediately after the sintering is measured on an as-sintered sample in principle. If the sample is large in surface roughness, both the surfaces are roughly ground to attain a surface roughness Ra of 0.3 $\mu$m or less. The reason for rough grinding is that excessive grinding may alter the warp conditions produced by the sintering.

EXAMPLE 1

The following powders were prepared:
The main constituents:

> an aluminum nitride (AlN) powder having an average particle diameter of 1 $\mu$m,
> a silicon nitride ($Si_3N_4$) powder having an average particle diameter of 1 $\mu$m, and
> an aluminum oxide ($Al_2O_3$) powder having an average particle diameter of 1 $\mu$m.

The sintering-agent constituents:

> a $Y_2O_3$ powder having an average particle diameter of 0.6 $\mu$m,
> a CaO powder having an average particle diameter of 0.3 $\mu$m,
> an $Nd_2O_3$ powder having an average particle diameter of 0.5 $\mu$m,
> a $Yb_2O_3$ powder having an average particle diameter of 0.6 $\mu$m,
> an $SiO_2$ powder having an average particle diameter of 0.8 $\mu$m, and
> an MgO powder having an average particle diameter of 0.7 $\mu$m.

Table 1 shows the combination and weight ratios of powders for individual samples. The powders were mixed by a ball mill for 24 hours together with an ethanol solvent. Samples 26 to 29 having an aluminum oxide as the main constituent are different from other samples in showing their constituents and weight ratios in Table 1; their chemical formulae are followed by a used weight percent. The mixed powders were further mixed with an organic binder PVB, of which the amount was 10 parts by weight per 100 parts of the total powders, to provide a mixed slurry. The slurry was converted into the form of a sheet by the doctor blade method. The thickness of the sheet was adjusted to become 0.5 mm after the sintering. Formed bodies were cut from the completed sheets to become a 100-mm square after the sintering. Subsequently, the binder was removed from the formed bodies.

Various materials for setters and powders were prepared as shown in the column "charging method for sintering" in Table 1. The samples were sintered with these materials, charging methods, and sintering conditions as shown in Table 1. The atmospheric gas was nitrogen ($N_2$) for all samples as shown in Table 1. The gas was supplied at a flow rate of 30 liter/min during the temperature rising and cooling periods below the melting point of the sintering agents and at a flow rate of 30 liter/min multiplied by "r" shown in Table 1 during the period where the temperature was the melting point of the sintering agents or higher. For example, the flow rate was reduced to 4.5 liter/min for Sample 1 and 15 liter/min for Sample 16 during the period where the temperature was the melting point of the sintering agents or higher. With Sample 17, since the "r" was 100%, the flow rate was maintained at 30 liter/min during the whole period of sintering. The temperature in Table 1 shows a maximum temperature at which the samples were kept for four hours.

With Samples 1 to 17, 21, 26, and 27, a setter made of a BN sintered body with a surface roughness Rmax of 5 $\mu$m was provided under five stacked formed bodies, and a setter consisting mainly of the material shown in Table 1 was provided between the formed bodies and on the uppermost formed body. All the setters have the same thickness of 0.5 mm. Of the setters, those for Samples 1 to 8, 21, 26, and 27 were prepared by press-forming the material shown in Table 1, impregnating a paste consisting mainly of a pure BN powder into the formed body, and heat-pressing the paste-impregnated formed body to obtain the form of a sheet. The setter for Sample 9 was a punched sintered plate of which the total volume of the through holes accounted for 30% of the total volume of the plate. The setters for Samples 10 to 17 were prepared by sintering a formed body made of the powder material shown in Table 1 at 1800°C in nitrogen. With Samples 18 to 20, five formed bodies were stacked on a setter made of a BN sintered body similar to that mentioned above and were embedded in the powder shown in the column "Charging method for sintering", with a powder layer made of the same material being placed between the formed bodies. With Samples 22, 23, and 28, five formed bodies were stacked on a setter made of a BN sintered body having a surface roughness Rmax of 5 μm. With Samples 24, 25, and 29, only one formed body was placed without using a setter in a closed container made of the same BN sintered body as used for the foregoing setter. The surface roughness of the setters is shown in Rmax in the column "Charging method for sintering" in Table 1.

Table 1

| Sample No. | Combination and weight ratios of powders (wt.%) | | | | | | Charging method for sintering | | Sintering atmosphere and temperature | | |
|---|---|---|---|---|---|---|---|---|---|---|---|
| | AlN | $Si_3N_4$ | $Y_2O_3$ | CaO | $Nd_2O_3$ | $Yb_2O_3$ | Setter | | Gas | r (%) | Temperature (°C) |
| | | | | | | | Material and type | Rmax (μm) | | | |
| 1 | 97.0 | - | 3.0 | - | - | - | W wool | 4 | $N_2$ | 15 | 1850 |
| 2 | 97.0 | - | 3.0 | - | - | - | BN plate | 4 | $N_2$ | 15 | 1850 |
| 3 | 97.0 | - | 1.5 | 1.5 | - | - | W wool | 4 | $N_2$ | 15 | 1700 |
| 4 | 97.0 | - | 1.5 | 1.5 | - | - | $ZrO_2$ cloth | 4 | $N_2$ | 15 | 1700 |
| 5 | 97.0 | - | 1.5 | 1.5 | - | - | $ZrO_2$ cloth | 2 | $N_2$ | 15 | 1700 |
| 6 | 97.0 | - | 1.5 | 1.5 | - | - | $ZrO_2$ cloth | 3 | $N_2$ | 15 | 1700 |
| 7 | 97.0 | - | 1.5 | 1.5 | - | - | $ZrO_2$ cloth | 5 | $N_2$ | 15 | 1700 |
| 8 | 97.0 | - | 1.5 | 1.5 | - | - | $ZrO_2$ cloth | 6 | $N_2$ | 15 | 1700 |
| 9 | 97.0 | - | 1.5 | 1.5 | - | - | BN plate | 5 | $N_2$ | 15 | 1700 |
| 10 | 97.0 | - | - | 0.5 | 1.0 | 1.5 | BN sheet | 5 | $N_2$ | 4 | 1700 |
| 11 | 97.0 | - | - | 0.5 | 1.0 | 1.5 | BN sheet | 5 | $N_2$ | 5 | 1700 |
| 12 | 97.0 | - | - | 0.5 | 1.0 | 1.5 | BN sheet | 5 | $N_2$ | 15 | 1700 |
| 13 | 97.0 | - | - | 0.5 | 1.0 | 1.5 | BN sheet | 5 | $N_2$ | 25 | 1700 |
| 14 | 97.0 | - | - | 0.5 | 1.0 | 1.5 | BN sheet | 5 | $N_2$ | 30 | 1700 |
| 15 | 97.0 | - | - | 0.5 | 1.0 | 1.5 | BN sheet | 5 | $N_2$ | 32 | 1700 |
| 16 | 97.0 | - | - | 0.5 | 1.0 | 1.5 | BN sheet | 5 | $N_2$ | 50 | 1700 |

Table 1   (continued)

| Sample No. | Combination and weight ratios of powders (wt.%) | | | | | | Charging method for sintering | | Sintering atmosphere and temperature | | |
|---|---|---|---|---|---|---|---|---|---|---|---|
| | AlN | $Si_3N_4$ | $Y_2O_3$ | CaO | $Nd_2O_3$ | $Yb_2O_3$ | Setter | | Gas | r (%) | Temperature (°C) |
| | | | | | | | Material and type | Rmax (μm) | | | |
| 17 | 97.0 | - | - | 0.5 | 1.0 | 1.5 | BN sheet | 5 | $N_2$ | 100 | 1700 |
| 18 | 97.0 | - | - | 0.5 | 1.0 | 1.5 | Buried in BN powder | - | $N_2$ | 32 | 1700 |
| 19 | 97.0 | - | - | 0.5 | 1.0 | 1.5 | Buried in AlN powder | - | $N_2$ | 32 | 1700 |
| 20 | - | 97.0 | 1.5 | 1.5 | - | - | Buried in $Si_3N_4$ powder | - | $N_2$ | 15 | 1800 |
| 21 | - | 97.0 | 1.5 | 1.5 | - | - | $Si_3N_4$ Whisker | 3 | $N_2$ | 15 | 1800 |
| 22 | 97.0 | - | - | 0.5 | 1.0 | 1.5 | No setter, samples stacked | | $N_2$ | 5 | 1700 |
| 23 | - | 97.0 | 1.5 | 1.5 | - | - | No setter, samples stacked | | $N_2$ | 5 | 1800 |
| 24 | 97.0 | - | - | 0.5 | 1.0 | 1.5 | No setter, one sample | | $N_2$ | 5 | 1700 |
| 25 | - | 97.0 | 1.5 | 1.5 | - | - | No setter, one sample | | $N_2$ | 5 | 1800 |
| 26 | $Al_2O_3(89)$-CaO(5)-$SiO_2(3)$-MgO(3) | | | | | | $ZrO_2$ cloth | 5 | $N_2$ | 15 | 1600 |
| 27 | $Al_2O_3(89)$-CaO(5)-$SiO_2(3)$-MgO(3) | | | | | | $ZrO_2$ cloth | 5 | $N_2$ | 100 | 1600 |
| 28 | $Al_2O_3(89)$-CaO(5)-$SiO_2(3)$-MgO(3) | | | | | | No setter, samples stacked | | $N_2$ | 5 | 1600 |
| 29 | $Al_2O_3(89)$-CaO(5)-$SiO_2(3)$-MgO(3) | | | | | | No setter, one sample | | $N_2$ | 5 | 1600 |
| Note: Sample Nos. 22, 23, 24, 25, 28, and 29 are comparative examples. | | | | | | | | | | | |

On the completed samples thus provided, "a" and "b," i.e., the quantities of the sintering agent-elements in the regions neighboring the surfaces, and a warp in the direction of thickness were determined by the methods described earlier. Before the determination, both surfaces were roughly brush-ground to obtain a surface roughness of 0.3 μm in Ra. Measurements on several samples showed that the warp measured after the grinding was practically the same as the warp measured before the grinding. After the brush-grinding, the samples were heat-treated at 850 °C for an hour in the atmosphere. Table 2 shows the quantity ratio of the sintering agents between the two surfaces of the sintered body (a/b), the warp after the sintering, and the increment in the warp after the heat treatment.

Table 2

| Sample No. | Quantity ratio of sintering agents between the two surfaces of sintered body (a/b) | Warp after the sintering (μm/mm) | Increment in the warp after heat treatment (μm/mm) |
|---|---|---|---|
| 1 | 1.10 | $8.9 \times 10^{-2}$ | $1.4 \times 10^{-2}$ |
| 2 | 1.03 | $8.5 \times 10^{-2}$ | $1.2 \times 10^{-2}$ |
| 3 | 1.02 | $8.3 \times 10^{-2}$ | $1.1 \times 10^{-2}$ |
| 4 | 1.03 | $8.4 \times 10^{-2}$ | $1.0 \times 10^{-2}$ |
| 5 | 1.12 | $8.8 \times 10^{-2}$ | $1.3 \times 10^{-2}$ |
| 6 | 1.14 | $9.1 \times 10^{-2}$ | $1.5 \times 10^{-2}$ |
| 7 | 1.15 | $9.0 \times 10^{-2}$ | $1.6 \times 10^{-2}$ |
| 8 | 1.10 | $8.8 \times 10^{-2}$ | $1.4 \times 10^{-2}$ |
| 9 | 1.10 | $8.8 \times 10^{-2}$ | $1.4 \times 10^{-2}$ |
| 10 | 1.12 | $8.9 \times 10^{-2}$ | $1.4 \times 10^{-2}$ |
| 11 | 1.04 | $8.6 \times 10^{-2}$ | $1.2 \times 10^{-2}$ |
| 12 | 1.03 | $8.5 \times 10^{-2}$ | $1.2 \times 10^{-2}$ |
| 13 | 1.03 | $8.5 \times 10^{-2}$ | $1.2 \times 10^{-2}$ |
| 14 | 1.05 | $8.7 \times 10^{-2}$ | $1.3 \times 10^{-2}$ |
| 15 | 1.16 | $9.0 \times 10^{-2}$ | $1.8 \times 10^{-2}$ |
| 16 | 1.18 | $9.2 \times 10^{-2}$ | $1.9 \times 10^{-2}$ |
| 17 | 1.21 | $9.9 \times 10^{-2}$ | $2.0 \times 10^{-2}$ |
| 18 | 1.23 | $9.9 \times 10^{-2}$ | $2.0 \times 10^{-2}$ |
| 19 | 1.10 | $8.8 \times 10^{-2}$ | $1.3 \times 10^{-2}$ |
| 20 | 1.14 | $8.0 \times 10^{-2}$ | $0.9 \times 10^{-2}$ |
| 21 | 1.15 | $8.1 \times 10^{-2}$ | $0.8 \times 10^{-2}$ |
| 22 | 1.45 | $10.0 \times 10^{-2}$ | $21.5 \times 10^{-2}$ |
| 23 | 1.34 | $9.4 \times 10^{-2}$ | $15.5 \times 10^{-2}$ |
| 24 | 1.34 | $12.6 \times 10^{-2}$ | $5.0 \times 10^{-2}$ |
| 25 | 1.31 | $12.0 \times 10^{-2}$ | $3.6 \times 10^{-2}$ |
| 26 | 1.02 | $6.0 \times 10^{-2}$ | $1.3 \times 10^{-2}$ |
| 27 | 1.10 | $6.4 \times 10^{-2}$ | $1.1 \times 10^{-2}$ |
| 28 | 1.33 | $18.1 \times 10^{-2}$ | $-0.6 \times 10^{-2}$ |
| 29 | 1.31 | $14.3 \times 10^{-2}$ | $0.6 \times 10^{-2}$ |
| Note: Sample Nos. 22, 23, 24, 25, 28, and 29 are comparative examples. | | | |

The data in Table 2 demonstrate that the provision of setters reduces the distortion (warp) of sintered bodies. With aluminum oxide ceramics, the provision of setters significantly reduces the warp after the sintering and reduces the increment in the warp after the heat treatment following the sintering, showing the considerable effectiveness of the method offered by the present invention. It is evident that aluminum oxide ceramics are far smaller than ceramics consisting mainly of nitride in the increment in the warp after the heat treatment in an oxidative atmosphere after the sintering (one sample even showed a slight decrement instead of increment). This is because ceramics consisting mainly of oxide are minimally affected by the oxygen in the atmosphere since the heat treatment is carried out in an oxidative atmosphere. On the other hand, with ceramics consisting mainly of nitride, we found that the provision of setters has a great effect on the magnitude of distortion and on the reduction of the increment in the distortion after the heat treatment. This effect is greater on aluminum nitride ceramics than on silicon nitride ceramics. The foregoing results demonstrate that the reduction of sintering-agent quantity difference between the two surfaces expressed in a/b to 1.3 or less reduces the distortion after the sintering and particularly reduces the increment in the distortion after the heat treatment in an oxidative atmosphere after the sintering with ceramics consisting mainly of nitride. Samples 24, 25, and 29, in which only one formed body was charged, showed no equalization of the distribution of the sintering agents after the sintering and no reduction in the level of distortion.

EXAMPLE 2

An Ag paste was print-applied in a pattern of a 90-mm square onto the concave side of the main surfaces of every base-material sample produced in Example 1 to be dried and then baked at 850 °C for 30 minutes in the atmosphere. The resultant increment in the warp after the baking was comparable in level to that shown in Table 2 on every sample. Subsequently, an $SiO_2$-$Al_2O_3$-$B_2O_3$-based glass paste was print-applied onto the substrate having the Ag layer to be dried and then baked at 800 °C for 30 minutes in the atmosphere. The resultant increment in the warp after the baking was about one-half in level of that shown in Table 2 on every sample.

**Claims**

1.    A ceramic base material having one or more sintering agents, the base material satisfying the following formula:

$$a/b \leq 1.3,$$

where

  a: the larger of c1 and c2,
  b: the smaller of c1 and c2,
  c1: the ratio "k" at a main-surface side,
  c2: the ratio "k" at the other main-surface side,

$$k=s/m,$$

  s: the fluorescent X-ray-detected strength of the constituent elements of the sintering agents,
  m: the fluorescent X-ray-detected strength of the main-constituent elements.

2.    A ceramic base material as defined in claim 1, wherein the ceramic consists mainly of a nitride material.

3.    A ceramic base material as defined in claim 2, wherein the ceramic comprises or consists of an aluminum nitride ceramic.

4.    A ceramic base material as defined in any one of claims 1 to 3, wherein the sintering agent is selected from one or more of $Y_2O_3$, CaO, $Nd_2O_3$, $Yb_2O_3$, $SiO_2$ and MgO.

5.    A substrate for mounting a semiconductor device which comprises or consists of a ceramic base material as defined in any one of claims 1 to 4.

6.    A semiconductor device mounted on a substrate as defined in claim 5.

FIG. 1

## EUROPEAN SEARCH REPORT

**European Patent Office**

Application Number

EP 99 30 5372

### DOCUMENTS CONSIDERED TO BE RELEVANT

| Category | Citation of document with indication, where appropriate, of relevant passages | Relevant to claim | CLASSIFICATION OF THE APPLICATION |
|---|---|---|---|
| X | PATENT ABSTRACTS OF JAPAN vol. 017, no. 270 (C-1063), 26 May 1993 (1993-05-26) & JP 05 009076 A (MURATA MFG CO. LTD.), 19 January 1993 (1993-01-19) * abstract; figure 2 * --- | 1-6 | C04B35/581 H01L23/15 C04B35/64 C04B35/58 |
| X | EP 0 629 595 A (W.R. GRACE & CO.-CONN.) 21 December 1994 (1994-12-21) * page 3, line 1 - line 10; examples 1-4 * * page 4, line 36 - line 54 * * page 6, line 7 - line 19 * ----- | 1-6 | |

TECHNICAL FIELDS SEARCHED

C04B
H01L

The present search report has been drawn up for all claims

| Place of search | Date of completion of the search | Examiner |
|---|---|---|
| THE HAGUE | 17 September 1999 | Hauck, H |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03 82 (P04C01)

**EP 0 970 932 A1**

## ANNEX TO THE EUROPEAN SEARCH REPORT
## ON EUROPEAN PATENT APPLICATION NO.

EP 99 30 5372

This annex lists the patent family members relating to the patent documents cited in the above-mentioned European search report.
The members are as contained in the European Patent Office EDP file on
The European Patent Office is in no way liable for these particulars which are merely given for the purpose of information.

17-09-1999

| Patent document cited in search report | | Publication date | Patent family member(s) | | Publication date |
|---|---|---|---|---|---|
| JP 05009076 | A | 19-01-1993 | NONE | | |
| EP 629595 | A | 21-12-1994 | US | 4920640 A | 01-05-1990 |
| | | | AT | 122651 T | 15-06-1995 |
| | | | AU | 2879389 A | 27-07-1989 |
| | | | DE | 68922635 D | 22-06-1995 |
| | | | DE | 68922635 T | 05-10-1995 |
| | | | EP | 0329973 A | 30-08-1989 |
| | | | JP | 2005449 A | 10-01-1990 |
| | | | US | 5017434 A | 21-05-1991 |
| | | | US | 5028650 A | 02-07-1991 |
| | | | US | 5073526 A | 17-12-1991 |
| | | | US | 5102749 A | 07-04-1992 |
| | | | US | 5250130 A | 05-10-1993 |

EPO FORM P0459

For more details about this annex : see Official Journal of the European Patent Office, No. 12/82

13